# EUROPEAN PATENT APPLICATION

(11) **EP 4 651 007 A1**
(43) Date of publication of application: **19.11.2025**
(21) Application number: 24176733.4
(22) Date of filing: 17.05.2024
(51) Int. Cl.: G06F 30/13, G06F 30/27, G06N 3/0475, G06N 3/08

(54) **METHOD AND SYSTEM FOR CREATING A CONFIGURATION LIST OF FIRE SAFETY SYSTEM ELEMENTS FROM AN ICHNOGRAPHICAL INSTANCE OF A BUILDING FLOOR PLAN**

(71) Applicant: Siemens Schweiz AG, 8047 Zürich (CH)
(72) Inventor: Farnik, Michal, 6317 Oberwil Bei Zug (CH); Rozas Lera, Emanuele, 8134 Adliswil (CH)
(74) Representative: Siemens Patent Attorneys

(57) **Abstract**

The present disclosure relates to a method for creating a configuration list of fire safety system elements from an ichnographical instance of a building floor plan. The method comprises receiving, by an artificial intelligence, AI, processor of an AI module, a data file containing an ichnographical instance of a building floor plan. The method further comprises extracting, by the AI processor, geometrical data patterns in the ichnographical instance of the building floor plan contained in the received data file. In addition, the method comprises associating, by the AI processor, the extracted geometrical data patterns with metadata indicating fire safety system elements according to an operative reference rule set derived by self-learning performed by an interpreter rule generator of the AI module. Further, the method comprises compiling a structured alphanumerical configuration list of fire safety system elements corresponding to the building floor plan based on the associated metadata generated by the AI processor. The present disclosure further relates to a system for creating a configuration list of fire safety system elements from an ichnographical instance of a building floor plan.

## Description

The present disclosure relates to a method and a system for creating a configuration list of fire safety system elements from an ichnographical instance of a building floor plan. Further, the present disclosure relates to a non-transitory machine-readable medium and a computer program.

When planning the interior design of a building based on a picture of a floor plan of the building, a building automation technician, for example a fire technician, conventionally manually defines the structure of the configuration list for building automation devices. This usually involves identifying the structure of spaces, such as rooms, corridors, doors and the like, the dimensions associated with those spaces, such as room width, room depth, and room height, and possibly distinguishing information regarding the intended purpose of the spaces, such as room designations, types of building facilities and similar. The technician then uses his expert knowledge to associate a set of building automation devices, for example elements in a fire safety system, such as fire detectors, sprinklers, manual call points, notification devices, fireproof doors, and/or emergency exits, according to pre-defined rules based on building automation standards, local codes of practices, or other specified rules or guidelines.

In order to speed up the establishing of the configuration lists, computer-assisted algorithms may be employed. Document US 2023/0409771 A1 discloses methods for extracting elements of a design drawing area of an image of a floor plan drawing to enrich the floor plan drawing with a symbol-based building information model. Document US 2022/0198572 A1 discloses a computer-implemented method of using trained machine learning models and optical character recognition to translate data in a real property floor plan drawing into structured floor plan data for assigning attributes to the floor plan data relevant to insurance policy management.

Hence, there may be a need for more efficient ways to create configuration files for a building automation system from a printed geometric layout of a building floor plan. Against this background, the problem addressed by the present invention is that of providing an automated procedure for generating building-specific configuration lists of elements of a fire safety system without the need to re-generate floor plan models in CAD conformity from drawn floor plans with sparse information.

This problem is solved according to the invention by a method for creating a configuration list of fire safety system elements from an ichnographical instance of a building floor plan having the features of claim 1, by a system for creating a configuration list of fire safety system elements from an ichnographical instance of a building floor plan having the features of claim 10, and/or by a non-transitory machine-readable medium and a computer program having the features of claims 14 and 15, respectively.

According to a first aspect, there is provided a method for creating a configuration list of fire safety system elements from an ichnographical instance of a building floor plan. The method comprises receiving, by an artificial intelligence, AI, processor of an AI module, a data file containing an ichnographical instance of a building floor plan. The method further comprises extracting, by the AI processor, geometrical data patterns in the ichnographical instance of the building floor plan contained in the received data file. In addition, the method comprises associating, by the AI processor, the extracted geometrical data patterns with metadata indicating fire safety system elements according to an operative reference rule set derived by self-learning performed by an interpreter rule generator of the AI module. Further, the method comprises compiling a structured alphanumerical configuration list of fire safety system elements corresponding to the building floor plan based on the associated metadata generated by the AI processor.

The method may be computer-implemented and may be carried out by any suitable data processor, computation device, or the like. The method may be carried out by a single entity or by multiple entities, a distributed computer system, etc.

In a further aspect, there is provided a non-transitory machine-readable medium having stored thereon a (computer) program having a program code for performing the method according to the first aspect and/or the method according to the second aspect, when the program is executed on a processor or a programmable hardware. Examples may also cover program storage devices, such as digital data storage media, which are machine-, processor- or computer-readable and encode and/or contain machine-executable, processor-executable or computer-executable programs and instructions. Program storage devices may include or be digital storage devices, magnetic storage media such as magnetic disks and magnetic tapes, hard disk drives, or optically readable digital data storage media, for example. Other examples may also include computers, processors, control units, (field) programmable logic arrays ((F)PLAs), (F)PGA), graphics processor units (GPU), ASICs, integrated circuits (ICs) or system-on-a-chip (SoCs) systems programmed to execute the steps of the methods described above.

In a further aspect, there is provided a (computer) program having a program code for performing the method according to the first aspect, when the program is executed on a processor or a programmable hardware. Thus, steps, operations or processes of different ones of the methods described above may also be executed by programmed computers, processors or other programmable hardware components.

In certain other aspects, there is provided a system for creating a configuration list of fire safety system elements from an ichnographical instance of a building floor plan. The system comprises an input interface configured to be coupled to a communication network and to receive a data file containing an ichnographical instance of a building floor plan. The system further comprises a system processor coupled to the input interface and configured to process the received data file. The system further comprises an artificial intelligence, AI, module. The AI module comprises an AI processor, an interpreter rule memory coupled to the AI processor, and an interpreter rule generator operating with self-learning algorithms coupled to the AI processor. The AI processor is configured to retrieve a request containing the received data file from the system processor, to extract geometrical data patterns in the ichnographical instance of the building floor plan contained in the received data file, and to associate the extracted geometrical data patterns with metadata indicating fire safety system elements according to the operative reference rule set stored in the interpreter rule memory. The operative reference rule set is derived by self-learning performed by the interpreter rule generator. Moreover, the system comprises an output interface coupled to the system processor and configured to output a structured alphanumerical configuration list of fire safety system elements corresponding to the building floor plan. The structured alphanumerical configuration list is compiled by the system processor based on the associated metadata generated by the AI processor.

Advantageous configurations and developments emerge from the further dependent claims and from the description with reference to the figures of the drawings.

In some implementations, the interpreter rule generator comprises at least one of a generative adversarial neural network, a recurrent neural network, a feedforward neural network, a restricted Boltzmann machine, a generative pre-trained transformer network, a large language model, a support vector classifier, a Monte Carlo network, a random forest classifier, a decision tree classifier, a conditional random field classifier, a hidden Markov chain classifier, and a Bayesian classifier

In some implementations, the fire safety system elements includes one or more of portable fire extinguishers, fire alarms, sprinklers, other fire extinguishing accessories such as portable water hoses, manual call points, notification devices, fireproof doors, and/or emergency exits.

In some implementations, the structured alphanumerical configuration list of fire safety system elements is contained in a tabulated data file. This tabulated data file may, in a few embodiments, output via a communication network to one or more computing devices connected to the communication network, such as for example the Internet or a local area network. Alternatively, in some other implementations, the structured alphanumerical configuration list of fire safety system elements may be structured in any other data file format suitable for further processing of a tool for configuring the fire safety system.

In some implementations, an updated structured alphanumerical configuration list of fire safety system elements corresponding to the building floor plan data file is compiled when the ichnographical instance of a building floor plan is altered or augmented by a user of a computing device. Then, the updated structured alphanumerical configuration list is output to the computing device via the communication network.

In some implementations, the operative reference rule set is generated on the basis of a training rule set from detected regularities and patterns in the training data of the ichnographical instances of exemplary building floor plans by the interpreter rule generator.

In some implementations, the ichnographical instance of the building floor plan includes a scan of a manual floor plan drawing or a technical drawing established with a general-purpose drawing software.

Where appropriate, the above-mentioned configurations and developments can be combined implementations can be combined with each other as desired, as far as this is reasonable. Further possible configurations, developments and implementations of the invention also include combinations, which are not explicitly mentioned, of features of the invention which have been described previously or are described in the following with reference to the embodiments. In particular, in this case, a person skilled in the art will also add individual aspects as improvements or supplements to the basic form of the present invention.

The present invention is described in greater detail in the following on the basis of the embodiments shown in the schematic figures of the drawings, in which
Fig. 1 illustrates a schematic block diagram of an example of a system for creating a configuration list of fire safety system elements from an ichnographical instance of a building floor plan according to an embodiment;
Fig. 2 illustrates a flow chart of an exemplary method for creating a configuration list of fire safety system elements from an ichnographical instance of a building floor plan; and
Fig. 3 schematically depicts an example of a user interface accessing the system of Fig. 1 according to an embodiment.

The appended drawings are intended to provide further understanding of the embodiments of the invention. They illustrate embodiments and, in conjunction with the description, help to explain principles and concepts of the invention. Other embodiments and many of the advantages mentioned become apparent in view of the drawings. The elements in the drawings are not necessarily shown to scale.

In the drawings, like, functionally equivalent and identically operating elements, features and components are provided with like reference signs in each case, unless stated otherwise. It is noted that in this disclosure, independent of the grammatical term usage, individuals with male, female or other gender identities are included within the term.

Although the present invention has been described in the above by way of embodiments, it is not limited thereto, but rather can be modified in a wide range of ways. In particular, the invention can be changed or modified in various ways without deviating from the core of the invention.

In the following description, reference is made to self-learning algorithms, which are used in an artificial intelligence (Al) system. Generally speaking, a self-learning algorithm emulates cognitive functions that are assigned to a human thinking performance according to human judgment. In doing so, by adding new training information, the self-learning algorithm can dynamically adapt the knowledge previously gained from old training information to the changed circumstances in order to recognize and extrapolate patterns and regularities in the totality of the training information.

In self-learning algorithms within the meaning of the present disclosure, all types of training forming human cognition can be used, such as supervised learning, semi-supervised learning, autonomous learning based on generative, non-generative or deep adversarial networks ("AN"), reinforcement learning or active learning. Feature-based learning ("representation learning") can be used in each instance. In particular, the self-learning algorithms within the meaning of the present disclosure may perform iterative adaptation of parameters and features to be learned via feedback analysis.

A self-learning algorithm within the meaning of the present disclosure may be based on a support vector classifier (SVC), a neural network such as a convolutional neural network (CNN), a Kohonen network, a recurrent neural network, a time-delayed neural network (TDNN), or an oscillatory neural network (ONN), a random forest classifier, a decision tree classifier, a Monte Carlo network, or a Bayesian classifier. In this regard, a self-learning algorithm in the sense of the present invention may employ feature-hereditary algorithms, k-means algorithms such as Lloyd's or MacQueen's algorithms, or TD learning algorithms such as SARSA or Q-learning.

Floor plans in building engineering may be rendered in ichnographical representation, i.e. in technical drawings to scale in which the relationships between rooms, spaces, walls, ducts, windows, pillars, doors and other physical features are shown at one level of a building in a top view. Ichnographical instances of floor plans may be enriched with indications of building details such as heaters, furnaces, electrical outlets, water pipes and similar. In order to plan a building, configuration lists of certain building automation devices customized for a specific building need to be created.

Specifically, fire safety systems need to be installed into buildings to ensure that people dwelling inside the building are protected in case a fire breaks out in the building. In other instances, industrial, manufacturing, warehousing and/or storage facilities may house potentially flammable materials, rendering adequate fire protection necessary to ensure suitable workplace safety, to minimize the potential for disruption of supply chains and to comply with commercial regulations. Data centers and server rooms likewise contain electronic equipment sensitive to temperature deviations caused by the operation of power intensive IT devices, mandating quickly reacting fire suppression assemblies.

Fire safety systems include fire safety system components or elements such as portable fire extinguishers, fire alarms, sprinklers, other fire extinguishing accessories such as portable water hoses, manual call points, notification devices, fireproof doors, and/or emergency exits. Configuration lists for such fire safety system components need to be established, indicating the rooms, corridors, stairwells and other physical structures with which specific fire safety system components are associated.

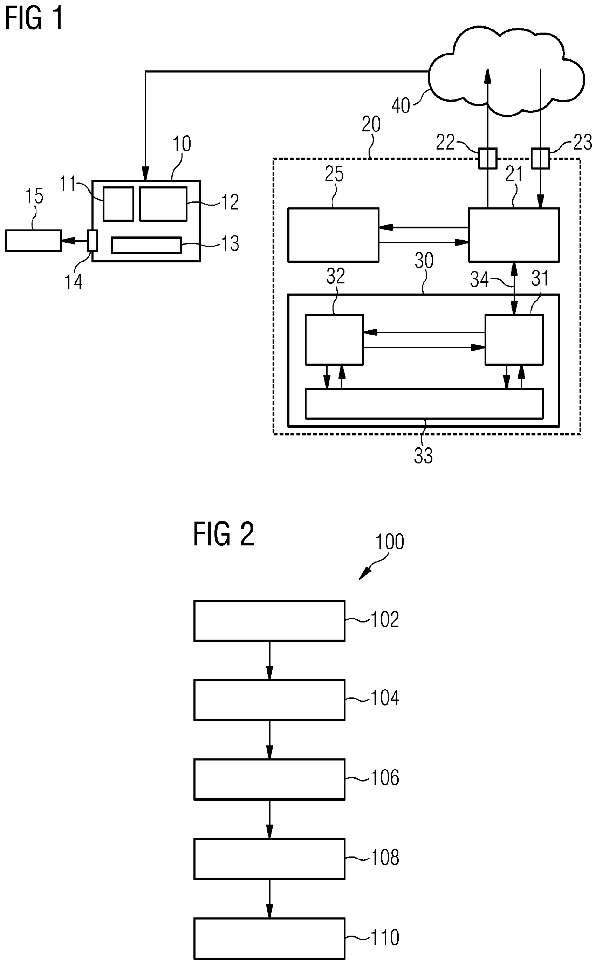

Fig. 1 illustrates a schematic block diagram of an example of a system 20 for creating a configuration list of fire safety system elements from an ichnographical instance of a building floor plan. The system 20 may be connected to a communication network 40, such as for example the Internet or a local area network of a company, which in turn interconnects various terminals and other communication nodes as network participants. For example, a computing device 10 having a central processing unit 11, a display 12, and one or more user input elements 13 such as microphones or other audio signal processing equipment, keyboards, mice, trackballs, touchpads or electronic styluses may be used to access the system 20 through the network 40. The computing device 10 may further have input/output interfaces 14 enabling the output of computing results from the central processing unit 11 to external periphery devices 15 such as printers, external memory devices or similar. The computing device 10 may for example be a personal computer (PC), a laptop, a tablet, a smartphone or any other suitable electronic data processing device.

The system 20 for creating a configuration list of fire safety system elements from an ichnographical instance of a building floor plan includes a system processor 21 having an output interface 22 and an input interface 23. The system processor 21 may receive an ichnographical instance of a building floor plan, for example as a picture file, via the input interface 23. For example, the ichnographical instance of a building floor plan may be a scan of a manual floor plan drawing or a crude technical drawing established with a simple general-purpose drawing software.

The system processor 21 may employ an AI module 30 included in the system 20 for extracting information from and interpreting drawing elements of the received ichnographical instance of the building floor plan. To that end, the AI module 30 includes an AI processor 31, an interpreter rule memory 32 coupled to the AI processor 31, and an interpreter rule generator 33 operating with self-learning algorithms coupled to the AI processor 31. The system processor 21 is connected to the AI module 30 by maintaining bidirectional data communication with the AI processor 31.

The AI module 30 is initially fed by the system processor 21 with a plurality of training data of baseline ichnographical instances of exemplary building floor plans. This training data may serve as a basis for the detection of regularities and patterns in the interpretation of the symbols, lines and other graphic items in the ichnographically illustrated building floor plans by means of the interpreter rule generator 33. The interpreter rule generator 33 may for example use a neural network - such as for example a generative adversarial neural network (GAN), a recurrent neural network (RNN), a feedforward neural network (FNN), or a restricted Boltzmann machine (RBM) -, a generative pre-trained transformer (GPT) network, a large language model (LLM), a support vector classifier, a Monte Carlo network, a random forest classifier, a decision tree classifier, a conditional random field (CRF) classifier, a hidden Markov chain (HMC) classifier, or a Bayesian classifier as a basis for acquiring, processing, analyzing and understanding ichnographically illustrated building floor plans in order to extract of hierarchically higher order conceptual information from the ichnographical instances for the purpose of producing linguistic, numerical and/or symbolic metadata associated with the building floor plan.

The interpreter rule generator 33 dynamically builds a training rule set from the detected regularities and patterns in the training data of the ichnographical instances of exemplary building floor plans which are initially stored in an internal memory of the interpreter rule generator 33. Once the training phase is ended (or the training phase is deemed to have been progressed far enough based on predefined training quality criteria), the interpreter rule generator 33 exports an operative reference rule set on the basis of the most advanced training rule set to the interpreter rule memory 32. The interpreter rule memory 32 stores the operative reference rule set that can then be accessed by the AI processor 31 upon retrieving a request 34 containing a data file with an ichnographical instance of a building floor plan under scrutiny from the system processor 21.

The AI processor 31 extracts geometrical data patterns in the ichnographical instance of the building floor plan contained in the received data file and associates the extracted geometrical data patterns with metadata indicating building automation devices according to the operative reference rule set for interpreting geometrical data patterns. The metadata is returned to the system processor 21 by the AI processor 31 which in turn compiles a structured alphanumerical configuration list based on the associated metadata generated by the AI processor. The structured alphanumerical configuration list may for example be a tabulated data file in which a correspondence between specific recognized items in the ichnographical instance of the building floor plan and certain fire safety system elements is established. In other words, the structured alphanumerical configuration list may indicate a conceptual mapping between fire safety system elements and building floor plan elements for the purpose of outfitting a building with a fire safety system in a systematic manner.

The structured alphanumerical configuration list of fire safety system elements corresponding to the building floor plan is then output by the system processor 21 via the output interface 22 to externally connected network devices, such as for example the computing device 10 schematically depicted in Fig. 1. The structured alphanumerical configuration list output by the system 20 may, without limitation of generality, be distributed throughout the communication network 40.

The structured alphanumerical configuration list output by the system 20 may for example be further processed at a computing device 10 in receipt of the list. To that end, a user may use the one or more user input elements 13 to generate user commands intended to alter, amend or otherwise re-format the structured alphanumerical configuration list. For example, the user may issue voice commands captured by specific audio input elements 13 or textual command captured by a keyboard as input element 13 which in turn are transmitted to a natural language processing model for interpreting user requests. The natural language processing model may either be implemented or run on the computing device 10 locally, on an external device accessible via the communication network 40, or on the system processor 21 in the system 20.

This way, the user is able to manipulate data items or the format of the structured alphanumerical configuration list. The system 20 therefore acts as a kind of assistant for a planner of a fire safety system. A system planner as user of the system 20 is able to engage in natural language interaction to enrich the created structured alphanumerical configuration list output by the system 20. For example, several entries in the list may be grouped up in fire safety system zones and automatically be labelled as such. Additionally or alternatively, a user may engage in natural language interaction to have the ichnographical instance 210 of the building floor plan altered or augmented based on the initially created structured alphanumerical configuration list output by the system 20. Such alteration or augmentation may, in turn, prompt the system 20 to provide an updated structured alphanumerical configuration list 220 of fire safety system elements corresponding to the building floor plan data file to the computing device 10 via the communication network 40.

The system processor 21 may additionally be coupled to a configuration memory 25 in order to store a history of previously established configuration lists. The history of previously established configuration lists may for example be used to implement a change management procedure: Upon receiving augmented or altered ichnographical instances of a building floor plan belonging to the same building, the system processor 21 may query the AI module 30 to create new metadata of the fire safety system elements and then compile a timestamped versioned history of the configuration list in which the changes with respect to previously established configuration lists may be highlighted. This enables a user to more easily track the changes in the fire safety system layout when the building floor plan changes over time.

Fig. 2 illustrates an exemplary method 100 for creating a configuration list of fire safety system elements from an ichnographical instance of a building floor plan. The method 100 may in particular be implemented using the system 20 as exemplarily illustrated in and explained in conjunction with Fig. 1.

In a first step 102, an artificial intelligence, AI, processor 31 of an AI module 30 receives a data file containing an ichnographical instance 210 of a building floor plan. The AI processor 31 extracts, in a second step 104, geometrical data patterns in the ichnographical instance 210 of the building floor plan contained in the received data file. The AI processor 31 then associates, in a third step 106, the extracted geometrical data patterns with metadata indicating fire safety system elements according to an operative reference rule set derived by self-learning performed by an interpreter rule generator 33 of the AI module 30. Finally, in a fourth step 108, a structured alphanumerical configuration list 220 of fire safety system elements corresponding to the building floor plan is compiled based on the associated metadata generated by the AI processor 31.

Optionally, the structured alphanumerical configuration list 220 of fire safety system elements is contained in a tabulated data file which may be output, in a fifth step 110, via a communication network 40 to one or more computing devices 10 connected to the communication network 40, such as for example the Internet or a local area network.

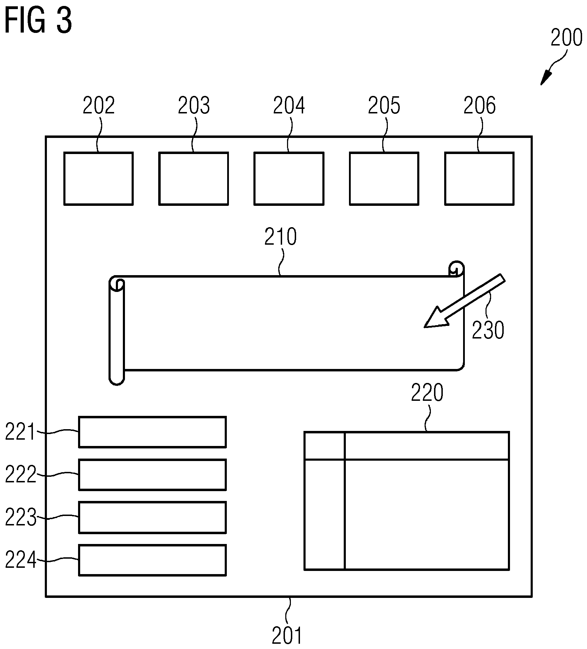

Fig. 3 schematically depicts an example of a user interface 200 accessing the system 20 of Fig. 1. The user interface 200 may for example be used in the method 100 as illustrated in and explained in conjunction with Fig. 2. The user interface 200 may for example be displayed by the display 12 of the computing device 10 connected to the system 20. The user interface 200 may display an ichnographical instance 210 of a building floor plan currently processed. The corresponding structured alphanumerical configuration list 220 of fire safety system elements corresponding to this building floor plan may be displayed as tabulated content as well.

The user interface 200 may be displayed in an application window 201 which includes various menu entries 202 to 206 for data operations, such as loading (202) a new ichnographical instance 210, saving (203) the current ichnographical instance 210, switching on (204) a modification mode for the current ichnographical instance 210, turning on (205) a real-time configuration list update for the structured alphanumerical configuration list 220 when the content of the current ichnographical instance 210 is altered, and turning on (206) an annotation mode for the current ichnographical instance 210 based on specific entries in the structured alphanumerical configuration list 220.

In the modification mode, a user may use a drawing tool such as an input stylus 230 on a touch-sensitive display to draw, alter or supplement graphical elements in the currently displayed ichnographical instance 210. Those graphical elements based on user input may then be taken into account by the system 20 as new or altered input for updating the structured alphanumerical configuration list 220. The real-time configuration list update may prompt the system 20 to periodically check for changes in the displayed ichnographical instance 210, for example when graphical elements have been rearranged or newly drawn, and to update the structured alphanumerical configuration list 220 in real-time. This enables the user to directly assess the impact of potential changes in the building floor plan on the composition and layout of the fire safety system, thereby facilitating a more efficient fire safety system planning.

The structured alphanumerical configuration list 220 may include various table fields, the display and/or inclusion in the list of which may be toggled with table configuration buttons 221 to 224. The various table fields may for example include room names, room type information, translations into other languages, room numbers, the type of fire safety system elements needed, the number of fire safety system elements planned in a specific room or in a room type in general, and the like.

### Bezugszeichenliste / List of Reference

- 10: Computing device
- 11: Central processing unit
- 12: Display
- 13: User input elements
- 14: Input/output interface
- 15: Periphery devices
- 20: System
- 21: System processor
- 22: Output interface
- 23: Input interface
- 25: Configuration memory
- 30: Al module
- 31: Al processor
- 32: Interpreter rule memory
- 33: Interpreter rule generator
- 34: Request
- 100: Method
- 102: Method step
- 104: Method step
- 106: Method step
- 108: Method step
- 110: Method step
- 200: User interface
- 201: Application window
- 202-206: Menu entries for data operations
- 210: Ichnographical instance
- 220: Structured alphanumerical configuration list
- 221-224: Table configuration buttons
- 230: Input stylus

## Claims

1. A method (100) for creating a configuration list (220) of fire safety system elements from an ichnographical instance (210) of a building floor plan, the method (100) comprising:
receiving (102), by an artificial intelligence, Al, processor (31) of an AI module (30), a data file containing an ichnographical instance (210) of a building floor plan;
extracting (104), by the AI processor (31), geometrical data patterns in the ichnographical instance (210) of the building floor plan contained in the received data file;
associating (106), by the AI processor (31), the extracted geometrical data patterns with metadata indicating fire safety system elements according to an operative reference rule set derived by self-learning performed by an interpreter rule generator (33) of the AI module (30); and
compiling (108) a structured alphanumerical configuration list (220) of fire safety system elements corresponding to the building floor plan based on the associated metadata generated by the AI processor (31).

2. The method (100) of claim 1, wherein the interpreter rule generator (33) comprises at least one of a generative adversarial neural network, a recurrent neural network, a feedforward neural network, a restricted Boltzmann machine, a generative pre-trained transformer network, a large language model, a support vector classifier, a Monte Carlo network, a random forest classifier, a decision tree classifier, a conditional random field classifier, a hidden Markov chain classifier, and a Bayesian classifier.

3. The method (100) of claim 1 or 2, wherein the fire safety system elements includes one or more of portable fire extinguishers, fire alarms, sprinklers, other fire extinguishing accessories such as portable water hoses, manual call points, notification devices, fireproof doors, and/or emergency exits.

4. The method (100) of any of the claims 1 to 3, wherein the structured alphanumerical configuration list (220) of fire safety system elements is contained in a tabulated data file.

5. The method (100) of claim 4, further comprising:
outputting (110) the tabulated data file via a communication network (40) to one or more computing devices (10) connected to the communication network (40).

6. The method (100) of claim 5, wherein the communication network (40) is the Internet or a local area network, LAN.

7. The method (100) of claim 5 or 6, wherein, when the ichnographical instance (210) of a building floor plan is altered or augmented by a user of a computing device (10), an updated structured alphanumerical configuration list (220) of fire safety system elements corresponding to the building floor plan data file is compiled and output to the computing device (10) via the communication network (40).

8. The method (100) of one of the claims 1 to 7, wherein the operative reference rule set is generated on the basis of a training rule set from detected regularities and patterns in the training data of the ichnographical instances of exemplary building floor plans by the interpreter rule generator (33).

9. The method of claim one of the claims 1 to 8, wherein the ichnographical instance (210) of the building floor plan includes a scan of a manual floor plan drawing or a technical drawing established with a general-purpose drawing software.

10. A system (20) for creating a configuration list (220) of fire safety system elements from an ichnographical instance (210) of a building floor plan, the system (20) comprising:
an input interface (23) configured to be coupled to a communication network (40) and to receive a data file containing an ichnographical instance (210) of a building floor plan;
a system processor (21) coupled to the input interface (23) and configured to process the received data file;
an artificial intelligence, Al, module (3) comprising an Al processor (31), an interpreter rule memory (32) coupled to the Al processor (31), and an interpreter rule generator (33) operating with self-learning algorithms coupled to the Al processor (31), the Al processor (31) being configured to retrieve a request (34) containing the received data file from the system processor (31), to extract geometrical data patterns in the ichnographical instance (210) of the building floor plan contained in the received data file, and to associate the extracted geometrical data patterns with metadata indicating fire safety system elements according to the operative reference rule set stored in the interpreter rule memory (32), the operative reference rule set being derived by self-learning performed by the interpreter rule generator (33); and
an output interface (22) coupled to the system processor (21) and configured to output a structured alphanumerical configuration list (220) of fire safety system elements corresponding to the building floor plan, the structured alphanumerical configuration list (220) being compiled by the system processor (21) based on the associated metadata generated by the AI processor (31).

11. The system (20) of claim 10, wherein the interpreter rule generator (33) comprises at least one of a generative adversarial neural network, a recurrent neural network, a feedforward neural network, a restricted Boltzmann machine, a generative pre-trained transformer network, a large language model, a support vector classifier, a Monte Carlo network, a random forest classifier, a decision tree classifier, a conditional random field classifier, a hidden Markov chain classifier, and a Bayesian classifier.

12. The system (20) of claim 10 or 11, wherein the fire safety system elements includes one or more of portable fire extinguishers, fire alarms, sprinklers, other fire extinguishing accessories such as portable water hoses, manual call points, notification devices, fireproof doors, and/or emergency exits.

13. The system (20) of any of the claims 10 to 12, further comprising a configuration memory (25) coupled to the system processor (21) and configured to store a history of previously established configuration lists (220).

14. A non-transitory machine-readable medium having stored thereon a program having a program code for performing the method (100) according to any one of claims 1 to 9, when the program is executed on a processor or a programmable hardware.

15. A computer program having a program code for performing the method (100) according to any one of claims 1 to 9, when the program is executed on a processor or a programmable hardware.

## Amended claims

### Amended claims in accordance with Rule 137(2) EPC.

1. A method (100) for creating a configuration list (220) of fire safety system elements from an ichnographical instance (210) of a building floor plan, the method (100) comprising:
receiving (102), by an artificial intelligence, Al, processor (31) of an Al module (30), a data file containing an ichnographical instance (210) of a building floor plan;
extracting (104), by the AI processor (31), geometrical data patterns in the ichnographical instance (210) of the building floor plan contained in the received data file;
associating (106), by the Al processor (31), the extracted geometrical data patterns with metadata indicating fire safety system elements according to an operative reference rule set derived by self-learning performed by an interpreter rule generator (33) of the Al module (30);
compiling (108) a structured alphanumerical configuration list (220) of fire safety system elements contained in a tabulated data file corresponding to the building floor plan based on the associated metadata generated by the AI processor (31); and
outputting (110) the tabulated data file via a communication network (40) to one or more computing devices (10) connected to the communication network (40),
**characterized in that**, when the ichnographical instance (210) of a building floor plan is altered or augmented by a user of a computing device (10) in natural language interaction, an updated structured alphanumerical configuration list (220) of fire safety system elements corresponding to the building floor plan data file is compiled and output to the computing device (10) via the communication network (40).

2. The method (100) of claim 1, wherein the interpreter rule generator (33) comprises at least one of a generative adversarial neural network, a recurrent neural network, a feedforward neural network, a restricted Boltzmann machine, a generative pre-trained transformer network, a large language model, a support vector classifier, a Monte Carlo network, a random forest classifier, a decision tree classifier, a conditional random field classifier, a hidden Markov chain classifier, and a Bayesian classifier.

3. The method (100) of claim 1 or 2, wherein the fire safety system elements includes one or more of portable fire extinguishers, fire alarms, sprinklers, other fire extinguishing accessories such as portable water hoses, manual call points, notification devices, fireproof doors, and/or emergency exits.

4. The method (100) of one of the claims 1 to 3, wherein the communication network (40) is the Internet or a local area network, LAN.

5. The method (100) of one of the claims 1 to 4, wherein the operative reference rule set is generated on the basis of a training rule set from detected regularities and patterns in the training data of the ichnographical instances of exemplary building floor plans by the interpreter rule generator (33).

6. The method of claim one of the claims 1 to 5, wherein the ichnographical instance (210) of the building floor plan includes a scan of a manual floor plan drawing or a technical drawing established with a general-purpose drawing software.

7. A system (20) for creating a configuration list (220) of fire safety system elements from an ichnographical instance (210) of a building floor plan, the system (20) comprising:
an input interface (23) configured to be coupled to a communication network (40) and to receive a data file containing an ichnographical instance (210) of a building floor plan;
a system processor (21) coupled to the input interface (23) and configured to process the received data file;
an artificial intelligence, AI, module (3) comprising an AI processor (31), an interpreter rule memory (32) coupled to the Al processor (31), and an interpreter rule generator (33) operating with self-learning algorithms coupled to the AI processor (31), the Al processor (31) being configured to retrieve a request (34) containing the received data file from the system processor (31), to extract geometrical data patterns in the ichnographical instance (210) of the building floor plan contained in the received data file, and to associate the extracted geometrical data patterns with metadata indicating fire safety system elements according to the operative reference rule set stored in the interpreter rule memory (32), the operative reference rule set being derived by self-learning performed by the interpreter rule generator (33); and
an output interface (22) coupled to the system processor (21) and configured to output a structured alphanumerical configuration list (220) of fire safety system elements contained in a tabulated data file corresponding to the building floor plan, the structured alphanumerical configuration list (220) being compiled by the system processor (21) based on the associated metadata generated by the AI processor (31),
**characterized in that** the Al processor (31) is further configured to, when the ichnographical instance (210) of a building floor plan is altered or augmented by a user in natural language interaction, compile an updated structured alphanumerical configuration list (220) of fire safety system elements corresponding to the building floor plan data file to be output via the communication network (40).

8. The system (20) of claim 7, wherein the interpreter rule generator (33) comprises at least one of a generative adversarial neural network, a recurrent neural network, a feedforward neural network, a restricted Boltzmann machine, a generative pre-trained transformer network, a large language model, a support vector classifier, a Monte Carlo network, a random forest classifier, a decision tree classifier, a conditional random field classifier, a hidden Markov chain classifier, and a Bayesian classifier.

9. The system (20) of claim 7 or 8, wherein the fire safety system elements includes one or more of portable fire extinguishers, fire alarms, sprinklers, other fire extinguishing accessories such as portable water hoses, manual call points, notification devices, fireproof doors, and/or emergency exits.

10. The system (20) of any of the claims 7 to 9, further comprising a configuration memory (25) coupled to the system processor (21) and configured to store a history of previously established configuration lists (220).

11. A non-transitory machine-readable medium having stored thereon a program having a program code for performing the method (100) according to any one of claims 1 to 6, when the program is executed on a processor or a programmable hardware.

12. A computer program having a program code for performing the method (100) according to any one of claims 1 to 6, when the program is executed on a processor or a programmable hardware.
